# EUROPEAN PATENT APPLICATION

(11) **EP 4 480 996 A1**
(43) Date of publication of application: **25.12.2024**
(21) Application number: 23756145.1
(22) Date of filing: 30.01.2023
(51) Int. Cl.: C08J 5/18, B29D 7/01, C08K 3/04, C08K 3/38, C08L 101/00, H01L 23/36

(54) **HEAT-CONDUCTIVE SHEET AND METHOD FOR PRODUCING HEAT-CONDUCTIVE SHEET**

(30) Priority: 18.02.2022 JP 2022023573
(71) Applicant: SHIN-ETSU CHEMICAL CO., LTD., Tokyo 1000005 (JP)
(72) Inventor: IMAIZUMI Keiji, Annaka-shi, Gunma 379-0224 (JP); TSUKADA Junichi, Annaka-shi, Gunma 379-0224 (JP)
(74) Representative: Sonnenhauser, Thomas Martin
(86) International application number: PCT/JP2023/002766
(87) International publication number: WO 2023/157617

(57) **Abstract**

The present invention is a thermally conductive sheet containing a thermally conductive filler (B) that contains at least one of carbon and boron nitride in a polymer matrix (A), wherein the thermally conductive sheet has a thermal conductivity in a thickness direction of 15 W/m·K or more and a degree of orientation in which a long axis direction of the thermally conductive filler is oriented in a thickness direction of the thermally conductive sheet is 1.0 or more. This makes the filler highly oriented, and thus it is possible to provide a thermally conductive sheet that has excellent thermal conductivity in a thickness direction and low specific gravity.

## Description

### TECHNICAL FIELD

The present invention relates to a thermally conductive sheet and a method for manufacturing of the same.

### BACKGROUND ART

In recent years, with the further improvement in the performance of electronic devices, high density of semiconductor elements and high-density mounting have progressed. Along with this, the amount of heat generated from the electronic components that make up electronic products has also increased, and it has become important to dissipate the heat efficiently. In order to dissipate the heat generated from a heat generating body, a heat radiator such as a heat sink, etc. is generally used. It is known that a heat dissipation sheet is placed between a heat generating body and a heat radiator to enhance thermal conduction efficiency.

In particular, a demand for heat-dissipating materials is increasing due to a remarkable shift to electronics in automobiles and an increase in the number of electronic materials to be mounted on them. The heat-dissipating materials include a sheet type and a grease type, but the sheet type is preferably used due to its easy mountability, etc. Further, with automated driving as a background, further improvement in thermal conductivity is required for such a heat-dissipating materials. Generally, for the purpose of high thermal conductivity, it is necessary to increase a filling rate of fillers dispersed in a polymer, so the specific gravity tends to be high, exceeding 2.0. This has become a problem in promoting weight reduction to improve fuel consumption in a gasoline vehicle and electricity consumption in an EV.

For example, patent document 1 proposes a method for manufacturing a thermally conductive resin sheet that includes at least; a curing step to obtain a cured product by extruding a thermally conductive composition containing a polymer, an anisotropic filler, and a filler using an extruder and then curing the extruded composition; and a cutting step of cutting the cured product at a predetermined thickness in a direction perpendicular to the extrusion direction using an ultrasonic cutter.

Additionally, for example, patent document 2 also proposes a method for manufacturing a thermally conductive sheet, in which a thermally conductive composition containing a polymer, an anisotropic filler, and a filler is exposed to a magnetic field to orient the anisotropic thermally conductive filler, formed in a block, and then sliced in a desired thickness.

Further, for example, patent document 3 also proposes a method for manufacturing a thermally conductive sheet, the method including molding a thermally conductive composition containing a polymer, an anisotropic filler, and a filler to have a thickness of 20 times or less the average value of the long axis of the anisotropic filler by rolling molding, press molding, extrusion molding, or coating to prepare an oriented primary sheet; laminating the sheets; and slicing the laminated body to form thermally conductive sheets.

However, patent documents 1 to 3 do not indicate specific gravity. Therefore, it has been desired to obtain a thermally conductive sheet having low specific gravity.

### CITATION LIST

### PATENT LITERATURE

Patent Document 1: JP 2012-023335 A
Patent Document 2: JP 2019-186555 A
Patent Document 3: JP 2017-126614 A

### SUMMARY OF INVENTION

### TECHNICAL PROBLEM

That is, an object of the present invention is, thanks to having a filler highly oriented, to provide a thermally conductive sheet that has excellent thermal conductivity in a thickness direction and low specific gravity.

### SOLUTION TO PROBLEM

To solve the above problem, the present invention provides a thermally conductive sheet comprising a thermally conductive filler (B) including at least one of carbon and boron nitride in a polymer matrix (A), wherein the thermally conductive sheet has a thermal conductivity in a thickness direction of 15 W/m·K or more and a degree of orientation in which a long axis direction of the thermally conductive filler is oriented in a thickness direction of the thermally conductive sheet is 1.0 or more.

Such a thermally conductive sheet, by taking advantage of the anisotropy of the thermally conductive filler, has high thermal conductivity even with a low filler content and a low specific gravity. Carbon or boron nitride is known to have the lowest specific gravity among thermally conductive fillers, making it most suitable to achieve low specific gravity.

The thermally conductive sheet has preferably a specific gravity of less than 2.0.

With such a specific gravity, it is suitable as a thermally conductive sheet.

The proportion of the component (B) contained in the thermally conductive sheet is preferably 50 to 90 mass%.

Such a thermally conductive sheet has an advantage in achieving both high thermal conductivity and low specific gravity.

The component (A) is preferably a curable polymer composition comprising at least one selected from the group consisting of organopolysiloxanes, polyurethanes, polyacrylates, perfluoropolyether elastomers, unsaturated polyester resins, polyamide resins, epoxy resins, and phenolic resins.

With such a component (A), the component (B) has suitable fillability.

A shape of the component (B) is preferably fibrous, scaly, plate-like, flat, needle-like, or whisker.

Such a thermally conductive filler makes it easier to be aligned when orienting the thermally conductive filler.

An aspect ratio of the component (B) is preferably 2 or more.

With such a thermally conductive filler, when the filler is oriented in the longitudinal direction, the number of times that heat moves between the fillers is reduced, and as a result, the fillers improve the thermal conductivity in the longitudinal direction.

The present invention provide a method for manufacturing the thermally conductive sheet, comprising:
(I-1) a preparing step of preparing a filler-containing resin composition comprising the polymer matrix (A) and the thermally conductive filler (B);
(I-2) a filling step of filling a mold with the filler-containing resin composition;
(I-3) a vibrating step of defoaming and aligning the fillers by vibrating the mold with ultrasonic waves;
(I-4) a heating step of heating the filler-containing resin composition to obtain a string-shaped filler-containing semi-cured resin composition;
(I-5) a molding step of aligning the string-shaped filler-containing semi-cured resin compositions in a longitudinal direction and then subjecting the compositions to heating and pressurization to obtain a filler-containing molded body; and
(I-6) a slicing step of slicing the filler-containing molded body to obtain thermally conductive sheets.

Additionally, the present invention provides a method for manufacturing the thermally conductive sheet, comprising:
(II-1) a preparing step of preparing a filler-containing resin composition comprising the polymer matrix (A) and the thermally conductive filler (B);
(II-2) an applying step of applying the filler-containing resin composition onto a film separator in a single direction so that the applied composition has a uniform thickness on the film separator;
(II-3) a heating step of heating the filler-containing resin composition to obtain a sheet-shaped filler-containing semi-cured resin composition;
(II-4) a cutting step of peeling off the sheet-shaped filler-containing semi-cured resin composition from the film separator, and then cutting the composition according to a size of a mold to be used in a molding step;
(II-5) the molding step of aligning cut pieces of the sheet-shaped filler-containing semi-cured resin composition in the direction of applying the resin composition and subjecting the cut pieces to heating and pressurization to obtain a filler-containing molded body; and
(II-6) a slicing step of slicing the filler-containing molded body to obtain a thermally conductive sheet.

According to either of these methods, it is possible to manufacture the inventive thermally conductive sheet having suitable thermal conductivity.

The filler-containing resin composition further comprises an organic solvent preferably.

Because viscosity of the above filler-containing resin composition decreases by adding an organic solvent, its fillability is improved and the component (B) becomes easy to be aligned to be able to have an improved degree of orientation.

### ADVANTAGEOUS EFFECTS OF INVENTION

According to the present invention, by highly orienting the thermally conductive fillers, it is possible to obtain a thermally conductive sheet that has excellent thermal conductivity in the thickness direction and has a low specific gravity.

### BRIEF DESCRIPTION OF DRAWINGS

FIG. 1 is a schematic diagram showing an example of a mold used in the filling step with a composition;
FIG. 2 is a schematic diagram showing the cross-sectional structure of FIG. 1;
FIG. 3 is a schematic diagram showing an example of a mold used in the molding step;
FIG. 4 is a schematic diagram showing a mold for molding a general 2 mm sheet;
FIG. 5 shows an SEM image of the surface of the thermally conductive sheet 1 of Example 1;
FIG. 6 shows a result of X-ray diffraction analysis of the surface of the thermally conductive sheet 1 of Example 1;
FIG. 7 shows an SEM image of the surface of the thermally conductive sheet 2 of Example 2;
FIG. 8 shows a result of X-ray diffraction analysis of the surface of the thermally conductive sheet 2 of Example 2;
FIG. 9 shows an SEM image of the surface of the thermally conductive sheet 3 of Example 3;
FIG. 10 shows a result of X-ray diffraction analysis of the surface of the thermally conductive sheet 3 of Example 3;
FIG. 11 shows an SEM image of the surface of the thermally conductive sheet 4 of Example 4;
FIG. 12 shows a result of X-ray diffraction analysis of the surface of the thermally conductive sheet 4 of Example 4;
FIG. 13 shows an SEM image of the surface of the thermally conductive sheet 5 of Example 5;
FIG. 14 shows a result of X-ray diffraction analysis of the surface of the thermally conductive sheet 5 of Example 5;
FIG. 15 shows an SEM image of the surface of the thermally conductive sheet 6 of Example 6;
FIG. 16 shows a result of X-ray diffraction analysis of the surface of the thermally conductive sheet 6 of Example 6;
FIG. 17 shows an SEM image of the surface of the thermally conductive sheet 7 of Comparative Example 1;
FIG. 18 shows a result of X-ray diffraction analysis of the surface of the thermally conductive sheet 7 of Comparative Example 1;
FIG. 19 shows an SEM image of the surface of the thermally conductive sheet 8 of Comparative Example 2;
FIG. 20 shows a result of X-ray diffraction analysis of the surface of the thermally conductive sheet 8 of Comparative Example 2;
FIG. 21 shows an SEM image of the surface of the thermally conductive sheet 9 of comparative Example 3;
FIG. 22 shows a result of X-ray diffraction analysis of the surface of the thermally conductive sheet 9 of comparative Example 3.

### DESCRIPTION OF EMBODIMENTS

As described above, there has been a demand for a thermally conductive sheet that has excellent thermal conductivity and low specific gravity.

The present inventors have earnestly studied the above problems to find that the thermally conductive sheet has a thermal conductivity of 15 W/m·K or more, when the degree of orientation, in which the long axis direction of a thermally conductive filler with anisotropy is oriented in a thickness direction of the thermally conductive sheet, is above a certain level or more, and completed the present invention.

That is, the present invention is a thermally conductive sheet comprising a thermally conductive filler (B) including at least one of carbon and boron nitride in a polymer matrix (A), wherein the thermally conductive sheet has a thermal conductivity in a thickness direction of 15 W/m·K or more and a degree of orientation in which a long axis direction of the thermally conductive filler is oriented in a thickness direction of the thermally conductive sheet is 1.0 or more. The upper limit of the thermal conductivity is not particularly limited, but may be, for example, 200 W/m-K or less. The upper limit of the degree of orientation is not particularly limited, but may be, for example, 1,000 or less.

In the present invention, the degree of orientation refers to a value calculated from peak intensity measured under the following conditions.

### [Degree of Orientation]

### (Measuring device)

Benchtop powder X-ray powder diffraction instrument
"D2 PHASER 2nd Generation"
manufacture by Bruker Japan K.K.

### (Measurement condition)

Sample size: Φ 12.7 mm
Scan range: 20 - 90°
Step size: 0.024°
Sample rotation: 10 rpm
Voltage: 30 kV
Current: 10 mA
The degree of orientation is calculated as follows based on the peak intensity of the measurement results.
Degree of Orientation = {vertical count sum + (diagonal count sum / 2)} / horizontal count
Vertical count 2Θ = 41.0 to 43.0° (100) plane, 2Θ = 76.5 to 78.5° (110 plane)
Diagonal count 2Θ = 43.5 to 45.5° (101) plane, 2Θ = 81.5 to 83.5° (112 plane)
Lateral count 2Θ = 25.5 to 27.5° (002) plane

The present invention will be described in detail below.

### [Thermally Conductive Sheet]

The inventive thermally conductive sheet is obtained by molding a filler-containing resin composition containing a thermally conductive filler that includes at least one of carbon and boron nitride in a polymer matrix according to the method described later. The details is described below.

### [Filler-Containing Resin Composition]

The filler-containing resin composition contains the component (A) polymer matrix and the component (B) thermally conductive filler.

### [(A) Polymer Matrix]

The component (A) polymer matrix is not particularly limited, but is at least one curable polymer composition preferably selected from the group consisting of organopolysiloxanes, polyurethanes, polyacrylates, perfluoropolyether elastomers, unsaturated polyester resins, polyamide resins, epoxy resins, and phenolic resins, in light of fillability of the component (B); more preferably organopolysiloxanes, perfluoropolyether elastomers, polyurethanes, and polyacrylates, which are excellent in flexibility; and further preferably organopolysiloxanes and perfluoropolyether elastomers, which are excellent in heat-resistance and cold resistance.

### [Curable Polymer Composition]

Therefore, the component (A) is preferably a curable organopolysiloxane composition or a curable perfluoropolyether elastomer composition.

### [Curable Organopolysiloxane Composition]

Hereinafter, a curable organopolysiloxane composition is described specifically.

Examples the curable organopolysiloxane composition include thermosetting organopolysiloxane compositions, moisture-curable organopolysiloxane compositions, and electron beam-curable silicone resins, etc. Examples of the thermosetting silicone resins include addition-curable organopolysiloxane compositions and peroxide-curable organopolysiloxane compositions, etc. Among them, the addition-curable organopolysiloxane compositions are preferable. And addition-curable organopolysiloxane compositions containing the following (A-1) to (A-3) are more preferable.
(A-1) Alkenyl group-containing organopolysiloxane
(A-2) Organohydrogenpolysiloxane
(A-3) Platinum group metal based curing catalyst

### [(A-1) Alkenyl Group-Containing Organopolysiloxane]

The component (A-1) alkenyl group-containing organopolysiloxane is an organopolysiloxane having two or more alkenyl groups bonded to a silicon atom in one molecule, and is a main agent in the inventive filler-containing resin composition, which provides a thermally conductive silicone cured product. Generally, the main chain portion basically consists of repeating of diorganosiloxane units, and this may include a branched structure as a part of the molecular structure or may be a cyclic structure. Especially, a linear diorganopolysiloxane is preferable from the viewpoint of physical properties such as mechanical strength of the cured product.

Examples of the above alkenyl groups include those having usually about 2 to 8 carbon atoms, such as a vinyl group, an allyl group, a propenyl group, an isopropenyl group, a butenyl group, a hexenyl group, and a cyclohexenyl group. Among these, lower alkenyl groups such as a vinyl group and an allyl group are preferable, and a vinyl group is particularly preferable. Note that, although two or more alkenyl groups exist preferably in the molecule, it is preferable that the alkenyl groups exist in a form connected only to the silicon atom at the end of the molecular chain in order to obtain a cured product having good flexibility.

The functional groups other than the alkenyl group are monovalent hydrocarbon groups, and examples thereof include alkyl groups such as a methyl group, a ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, and a dodecyl group; cycloalkyl groups such as a cyclopentyl group, a cyclohexyl group, and a cycloheptyl group; aryl groups such as a phenyl group, a tolyl group, a xylyl group, a naphthyl group, and a biphenylyl group; and aralkyl groups such as a benzyl group, a phenylethyl group, a phenylpropyl group, and a methylbenzyl group. Among these, they preferably have 1 to 10 carbon atoms, particularly 1 to 6 carbon atoms. More preferable groups are alkyl groups having 1 to 3 carbon atoms such as a methyl group, an ethyl group, a propyl group, and a 3,3,3-trifluoropropyl group, and a phenyl group. In addition, the functional groups other than the alkenyl groups bonded to the silicon atom are not limited to being all the same.

Usually, the kinematic viscosity of this organopolysiloxane at 25°C is preferably in the range of 10 to 100,000 mm²/s, and particularly preferably 5,000 to 100,000 mm²/s. When the kinematic viscosity is 10 mm²/s or more, the obtained resin composition has a storage stability. When it is 100,000 mm²/s or less, the obtained resin composition does not have poor extensibility.

Note that, in this specification, the kinetic viscosity is the value measured at 25°C using a Cannon-Fenske viscometer described in JIS Z 8803:2011.

One kind of the component (A-1) organopolysiloxane may be used alone, or two or more kinds of the components (A-1) having different viscosity may be used in a combination.

### [(A-2) Organohydrogenpolysiloxane]

The component (A-2) organohydrogenpolysiloxane is an organohydrogenpolysiloxane having at least 2, preferably 2 to 100, hydrogen atoms bonded directly to a silicon atom (a hydrosilyl group) per molecule in an average, and acts as a crosslinking agent for the component (A-1). That is, the hydrosilyl group in the component (A-2) is added to the alkenyl group in the component (A-1) by a hydrosilylation reaction promoted by the component (A-3) platinum group metal curing catalyst described later, to give a three-dimensional network structure having a crosslinked structure. Note that, when the number of hydrosilyl groups is less than 2, curing does not occur.

As the organohydrogenpolysiloxane, those represented by the following average structural formula (1) are used, but it is not limited thereto. 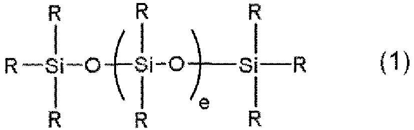 In the formula, R is independently a hydrogen atom or a monovalent hydrocarbon group containing no aliphatic unsaturated bond, and 2 or more, preferably 2 to 100, and more preferably 2 to 10 of Rs are hydrogen atoms in one molecule, and "e" is an integer of 1 or more, preferably an integer of 10 to 200.

In the general formula (1) above, examples of the monovalent hydrocarbon group R that does not contain an aliphatic unsaturated bond other than a hydrogen atom include alkyl groups such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, and a dodecyl group; cycloalkyl groups such as a cyclopentyl group, a cyclohexyl group, and a cycloheptyl group; aryl groups such as a phenyl group, a tolyl group, a xylyl group, a naphthyl group, and a biphenylyl group; and aralkyl groups such as a benzyl group, a phenylethyl group, a phenylpropyl group, and a methylbenzyl group. Among these, those having 1 to 10 carbon atoms, particularly 1 to 6 carbon atoms, are preferable. More preferably, they are alkyl groups having 1 to 3 carbon atoms such as a methyl group, an ethyl group, a propyl group, and a 3,3,3-trifluoropropyl group, and a phenyl group. In addition, Rs are not limited to be all the same.

The added amount of the (A-2) component is, for example, an amount in which the hydrosilyl group derived from the (A-2) component is 0.1 to 5.0 moles, preferably 0.3 to 2.0 moles, and more preferably 0.5 to 1.5 moles, relative to one mole of the alkenyl group derived from the (A-1) component. When the amount of the hydrosilyl group derived from the (A-2) component is 0.1 or more relative to one mole of the alkenyl group derived from the (A-1) component, the composition is cured sufficiently, and the strength of the cured product is sufficient to maintain the shape as a molded body, so that the composition is not insufficient in strength to be handled. Further, when the amount is 5.0 moles or less, the cured product has a good flexibility, and is not brittle.

### [(A-3) Platinum Group Metal Curing Catalyst]

The component (A-3) platinum group metal curing catalyst is a catalyst to promote the addition reaction between the alkenyl group derived from the component (A-1) and the hydrosilyl group derived from the component (A-2), and examples of such catalysts include catalysts well known for use in hydrosilylation reactions. Specific examples thereof include platinum group metal simple substances such as platinum (including platinum black), rhodium, and palladium; platinum chlorides such as H₂PtCl₄·nH₂O, H₂PtCl₆·nH₂O, NaHPtCl₆·nH₂O, KHPtCl₆·nH₂O, Na₂PtCl₆·nH₂O, K₂PtCl₄·nH₂O, PtCl₄·nH₂O, PtCl₂, Na₂HPtCl₄·nH₂O, wherein n is an integer of 0 to 6, preferably 0 or 6; chloroplatinic acid and chloroplatinic acid salts; alcohol-modified chloroplatinic acid (see specification of US 3220972 A); complexes of chloroplatinic acid and olefins (see specifications of US 3159601 A, US 3159662 A, and US 3775452 A); platinum group metals such as platinum black and palladium supported on supports such as alumina, silica, and carbon; rhodium-olefin complexes; chlorotris(triphenylphosphine)rhodium (Wilkinson's catalyst); complexes of platinum chloride, chloroplatinic acid, or chloroplatinate with vinyl group-containing siloxanes, particularly vinyl group-containing cyclic siloxanes; etc.

The amount of component (A-3) used may be an effective amount, is preferably 0.1 to 2,000 ppm, more preferably 50 to 1,000 ppm, in terms of the mass of the platinum group metal, based on the component (A-1). When the amount is 0.1 ppm or more, sufficient catalytic activity is obtained, and when the amount is 2,000 ppm or less, the effect of promoting the addition reaction is sufficient and costs can be lowered.

### [Curable Perfluoropolyether Elastomer Compositions]

Additionally, a curable perfluoropolyether elastomer composition, which is another preferable embodiment, will be specifically described also.

Examples of the curable perfluoropolyether elastomer compositions include a heat-curable perfluoropolyether elastomer composition, a moisture-curable perfluoropolyether elastomer composition, and an electron beam-curable perfluoropolyether elastomer, etc. Examples of the heat-curable perfluoropolyether elastomers include an addition-curable perfluoropolyether elastomer composition, a peroxide-curable perfluoropolyether elastomer composition, etc. Among these, an addition-curable perfluoropolyether elastomer composition is preferable, and an addition-curable perfluoropolyether elastomer composition containing the following (A-4) to (A-6) is preferable.
(A-4) Alkenyl group-containing perfluoropolyether compound,
(A-5) Fluorine-containing organohydrogenpolysiloxane
(A-6) Platinum group metal-based curing catalyst

### [Alkenyl Group-Containing Perfluoropolyether Compound]

The compound (A-4) alkenyl-containing perfluoropolyether compound is a perfluoropolyether compound having two or more alkenyl groups in one molecule, and is a main agent of the inventive filler-containing resin composition (which provides a cured product of the thermally conductive perfluoropolyether.). Usually, it is general that the main chain portion basically includes repeats of perfluoropolyether units (perfluorooxyalkylene units).

Among them, the compound represented by the following general formula (2) is preferred.

CH₂=CH-(X)_{z}-Rf¹-(X')_{z}-CH=CH₂ (2)

[In the formula (2) above, X is represented by -CH₂-, - CH₂O-, -CH₂OCH₂-, or -Y-NR¹-CO- (in this formula, Y is a bivalent group represented by a formula -CH₂- or a formula 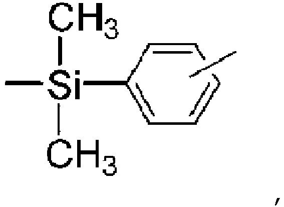
and R¹ is a hydrogen atom or a monovalent hydrocarbon group.),
X' is a divalent group represented by the formula -CH₂-, -CH₂O-, -CH₂OCH₂-, or -CO-NR¹-Y'- (in this formula, Y' is a bivalent group represented by a formula -CH₂- or a formula 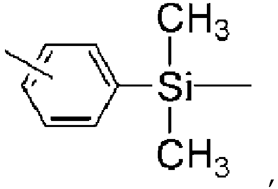
and R¹ is the same as above), and
Rf¹ is represented by the following general formulae (i) or (ii):

   -CₜF₂ₜ[OCF₂CF(CF₃)]ₚOCF₂(CF₂)ᵣCF₂O[CF(CF₃)CF₂O]_{q}C_{t'}F_{2t'}- (i)

   -CₜF₂ₜ[OCF₂CF(CF₃)]ᵤ(OCF₂)ᵥOC_{t'}F_{2t'}- (ii)
(in the formula (i) above, p and q are integers from 1 to 150, the average of the sum of p and q is 2 to 200, r is an integer from 0 to 6, and t and t' are 2 or 3. In the formula (ii), u is an integer from 1 to 200, v is an integer from 1 to 50, and t and t' are the same as above formula (i).]

The lower limit of the degree of polymerization (p+q) or (u+v) of the divalent perfluoropolyether group represented by Rf¹ is not particularly limited as long as it is an integer of 2 or more, but in order to have low pollution and low persistence, it is preferably 30 or more, particularly preferably 80 or more.

When R¹ is a monovalent hydrocarbon group, examples of the monovalent hydrocarbon groups include monovalent hydrocarbon groups having 1 to 20 carbon atoms, and specific examples include alkyl groups such as a methyl group, an ethyl group, a propyl group, a butyl group, a hexyl group, a cyclohexyl group, an octyl group, and a decyl group; alkenyl groups such as a vinyl group and a allyl group; aryl groups such as a phenyl group, a tolyl group, and a naphthyl group; and aralkyl groups such as a benzyl group and a phenylethyl group.

### [(A-5) Fluorine-Containing Organohydrogensiloxane]

The component (A-5) fluorine-containing organohydrogenpolysiloxane acts as a crosslinking agent or a chain-length extending agent for the above component (A-4). For this purpose, the above fluorine-containing organohydrogenpolysiloxane has two or more, preferably three or more, hydrogen atoms bonded to silicon atoms in one molecule (i.e., hydrosilyl groups). One kind of the components (A-5) can be used alone or two or more kinds thereof may be used in combination.

From the viewpoints of compatibility with the component (A-4), dispersibility, etc., the fluorine-containing organohydrogenpolysiloxane preferably has in one molecule one or more groups selected from the group consisting of perfluoroalkyl groups, perfluoroalkylene groups, perfluorooxyalkyl groups, and perfluorooxyalkylene groups. Examples of these perfluoro groups include those represented particularly by the following general formula.
Perfluoroalkyl groups:

   C_{g}F_{2g+1}-

   In the formula, g is an integer of 1 to 20, preferably 2 to 10.
Perfluoroalkylene group:

   -C_{g}F_{2g}-

   In the formula, g is the same as above.
Perfluorooxyalkyl group: 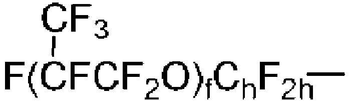 In the formula, f is an integer from 2 to 200, preferably from 2 to 100, and h is an integer from 1 to 3.
Perfluorooxyalkylene group: 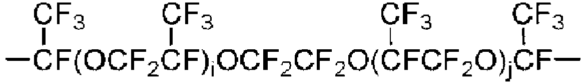 In the formula, i and j are integers of 1 or more, and the average of i+j is 2 to 200, preferably 2 to 100.

   -(CF₂CF₂O)ₖ(CF₂O)_{L}CF₂-

   In the formula, k and L are each an integer of 1 or more, and the average of k+L is 2 to 200, preferably 2 to 100.

In addition, the divalent linking group connecting these perfluoroalkyl groups, perfluorooxyalkyl groups, perfluoroalkylene groups, or perfluorooxyalkylene groups to a silicon atom may be an alkylene group, an arylene group, or a combination thereof, or these groups intervened by an ether bond, an amide bond, a carbonyl bond, or the like. Examples include those having 2 to 12 carbon atoms as follows.

-CH₂CH₂-,

-CH₂CH₂CH₂-,

-CH₂CH₂CH₂OCH₂-,

-CH₂CH₂CH₂-NH-CO-,

-CH₂CH₂CH₂-N(Ph)-CO-,

-CH₂CH₂CH₂-N(CH₃)-CO-,

-CH₂CH₂CH₂-O-CO-,

-Ph'-N(CH₃)-CO-

In the formula above, Ph represents a phenyl group, and Ph' represents a phenylene group.

In the component (A-5) fluorine-containing organohydrogenpolysiloxane, examples of the monovalent substituent groups bonded to a silicon atom other than the monovalent fluorine-containing substituents that is an organic group containing a perfluoroalkyl group or a perfluorooxyalkyl group include hydrocarbon groups having 1 to 20 carbon atoms, for example, unsubstituted hydrocarbon groups having 1 to 20 carbon atoms: alkyl groups such as a methyl group, an ethyl group, a propyl group, a butyl group, a hexyl group, a cyclohexyl group, an octyl group, and decyl group; alkenyl groups such as a vinyl group and an allyl group; aryl groups such as a phenyl group, a tolyl group, and a naphthyl group; and aralkyl groups such as a benzyl group and a phenylethyl group; etc. Further, the examples include also substituted hydrocarbon groups in which at least a part of hydrogen atoms of these hydrocarbon groups are substituted with a chlorine atom or the like, such as a chloromethyl group, a chloropropyl group, and a cyanoethyl group.

The component (A-5) fluorine-containing organohydrogenpolysiloxane may be cyclic, linear, three-dimensional network, or a combination thereof. The number of silicon atoms in this fluorine-containing organohydrogenpolysiloxane is not particularly limited, but is usually about 3 to 60, and preferably about 4 to 30.

The molecular weight of the component (A-5) fluorine-containing organohydrogenpolysiloxane is preferably in the range of 750 to 3,000, and more preferably 800 to 2,400.

A blended amount of the component (A-5) is an effective amount required to cure the component (A-4) and obtain a cured product having the desired rubber elasticity. In particular, the amount is such that hydrosilyl groups of the component (A-5) are supplied in an amount of 0.5 to 5.0 moles, preferably 1.0 to 2.0 moles, relative to one mole of the total of alkenyl groups that the component (A-4) in the composition has. When the supplied amount is sufficient, the degree of crosslinking is sufficient, and when it is not too much, chain extension is not prioritized, resulting in sufficient curing, no foaming during curing, and no decrease in the heat resistance, etc. of the obtained cured film.

### [(A-6) Platinum Group Metal-Based Curing Catalyst]

The component (A-6) platinum group metal curing catalyst is a catalyst for promoting the addition reaction between an alkenyl group derived from the component (A-4) and a hydrosilyl group derived from the component (A-5), and examples of such catalysts include those well known as catalysts used in hydrosilylation reactions. Specific examples of such catalysts include the same curing catalysts as those exemplified for the component (A-3) above.

The used amount of the component (A-6) may be an effective amount as a catalyst. For example, it is preferable to blend 0.1 to 500 ppm (by mass) in terms of platinum group metal with respect to the component (A-4) .

### [(B) Thermally Conductive Filler]

The inventive component (B) thermally conductive filler is selected from thermally conductive fillers containing at least one kind of carbon and boron nitride.

A shape of the thermally conductive filler is not particularly limited, but examples of the shape include a spherical, elliptical, plate-like, scaly, fibrous, flat, needle-like, crushed, and whisker shape. From a viewpoint that the oriented filler imparts thermal conductivity to a molded body, thermally conductive fillers having anisotropy such as a fibrous, scale, plate, flat, needle, or whisker shape is preferable. It is more preferable that the filler is fibrous.

The size of the above thermally conductive filler may also be selected as needed, and is not particularly limited, but the filler has preferably an aspect ratio (average long axis length/average short axis length) of 2 or more, and more preferably 5 or more. The upper limit is not particularly limited, but can be 500 or less, for example.

Such a thermally conductive filler is preferable, because the number of times that heat moves between the fillers is reduced when the filler is oriented in the longitudinal direction, and as a result, the fillers improve the thermal conductivity in the longitudinal direction.

When the above thermally conductive filler has anisotropy, its average length in the long axis and the short axis length can be measured by a scanning electron microscope (SEM), and the aspect ratio can be calculated from the measured values. For example, the aspect ratio of carbon fiber is the value of "average fiber length/average fiber diameter" of carbon fiber.

When the thermally conductive filler does not have anisotropy, such as a spherical shape, etc., its average particle size is a volume-based mean particle diameter (median diameter) of the particle size distribution measured by a laser diffraction scattering method (JIS R1629:1997) For example, it can be the volume-based cumulative average particle size (50% diameter in cumulative fraction) measured by a Microtrac MT3300EX, a particle size analyzer manufactured by MicrotracBEL Corp.

The thermally conductive filler may be used in combination with those having different shapes and sizes as needed.

The content of the component (B) in the inventive thermally conductive sheet is preferably 50 to 90 mass%, more preferably 55 to 85 mass%. This range is preferable because the thermally conductive filler in the inventive thermally conductive sheet is oriented to increase the thermal conductivity.

### [Other Components]

The above filler-containing resin composition can be further blended with components such as solvents, thixotropy-imparting agents, dispersants, curing agents, curing accelerators, retardants, slight-tackifiers, plasticizers, flame retardants, antioxidants, stabilizers, colorants, etc., as needed.

Further, the above filler-containing resin composition may contain a filler other than the component (B). Specific examples include silica and titanium oxide. The blended amount of the filler is not particularly limited, but is preferably 0 to 60 parts by mass, more preferably 0 to 40 parts by mass, based on 100 parts by mass of the component (A).

### [Method for Manufacturing Filler-Containing Resin Composition]

The above filler-containing resin composition can be manufactured by mixing the above polymer matrix, the above thermally conductive filler, and, if necessary, the above other components using a mixer or the like.

### [Method for Manufacturing Thermally Conductive Sheet]

The method for manufacturing the inventive thermally conductive sheet includes a molding step and a curing step of the above filler-containing resin composition, and examples thereof include the following methods.

### [Method for Manufacturing Thermally Conductive Sheet (I)]

One example of a method for manufacturing the inventive thermally conductive sheet is a method to obtain a thermally conductive sheet having excellent thermal conductivity in a thickness direction and low specific gravity by containing a high amount of the fillers through a process including:
(I-1) a preparing step of preparing a filler-containing resin composition comprising the polymer matrix (A) and the thermally conductive filler (B);
(I-2) a filling step of filling a mold with the filler-containing resin composition;
(I-3) a vibrating step of defoaming and aligning the fillers by vibrating the mold with ultrasonic waves;
(I-4) a heating step of heating the filler-containing resin composition to obtain a string-shaped filler-containing semi-cured resin composition;
(I-5) a molding step of aligning the string-shaped filler-containing semi-cured resin compositions in a longitudinal direction and then subjecting the compositions to heating and pressurization to obtain a filler-containing molded body; and
(I-6) a slicing step of slicing the filler-containing molded body to obtain thermally conductive sheets.

Hereinafter, each of the above steps is described in detail.

### Preparing step (I-1)

In this step, a filler-containing resin composition containing the polymer matrix (A) and the thermally conductive filler (B) are prepared according to a manufacturing method for the filler-containing resin composition.

### Filling step (I-2)

The prepared filler-containing resin composition is filled into a mold.

### (Mold used in the filling step)

The mold used in the filling step above has a width of 5.0 mm or less, a depth of the width + 1.0 mm or more, and a length of 10.0 mm or more. The bottom shape is not particularly limited but has one or more grooves, the shape of which may include, for example, a triangle, a semicircle, a wave, a flat plane, and the like.

### (Method for filling)

In the filling step, a specified amount of the filler-containing resin composition may be filled into the groove of the mold, or a large amount of the filler-containing resin composition may be filled and then the unnecessary portion may be scraped off with a squeegee or the like.

It is preferable to add a solvent (organic solvent) to the filler-containing resin composition, because the viscosity of the filler-containing resin composition decreases and its fillability is improved. Additionally, when defoaming and sedimentation of the thermally conductive fillers in the vibration step of the next step, the long axis directions of the thermally conductive fillers are easily aligned in a longitudinal direction of the string-shaped filler-containing semi-cured resin composition.

### Vibrating step (I-3)

The vibration step is performed by vibrating the mold with ultrasonic waves to defoam and align the thermally conductive fillers. In order to obtain a string-shaped filler-containing semi-cured resin composition in the next heating step, the mold is vibrated with ultrasonic waves to defoam, sediment, and orient the fillers, and the long axis directions of the fillers can be aligned in a longitudinal direction of the string-shaped filler-containing semi-cured resin composition.

### Heating step (I-4)

The heating step is a step to obtain the string-like filler-containing semi-cured resin composition by heating the filler-containing resin composition. In the case the filler-containing resin composition contains a solvent, the heating step also includes a step for volatilizing the solvent by heating.

### Molding step (I-5)

The obtained string-shaped filler-containing semi-cured resin compositions are alignded in a longitudinal direction and heated and pressurized to obtain a filler-containing molded body.

### (Mold used in the molding step)

The molds may have a concave shape with inner dimensions of width 10.0 mm or more, length 10.0 mm or more, and depth 10.0 mm or more. A lower mold may have a flat bottom shape, and an upper mold may have a shorter width and a shorter length than the inner dimensions of the lower mold by 0.01 to 0.2 mm respectively. There is no particular limit on the height of the upper mold, but it must be high enough to pressurize the upper mold.

### (Method for filling)

The string-shaped filler-containing semi-cured resin compositions obtained in the heating step above are filled into the lower mold as follows.
(i) The resin compositions are aligned in the mold so that their longitudinal directions are parallel to the X-axis direction, and then stacked in the Z-axis direction for filling.
(ii) The resin compositions are aligned in the mold so that their longitudinal directions are parallel to the Y-axis direction, and then stacked in the Z-axis direction for filling.

In this way, a molded body in which anisotropic fillers and the like are oriented can be obtained more preferably and efficiently.
The number of times that the resin compositions are stacked in the Z-axis direction is preferably two or more, and more preferably 5 to 3,000 times.

### (Method for molding)

In the molding step, the lower mold is pressed with the upper mold in the Z-axis direction and heated to completely cure the string-shaped filler-containing resin composition, thereby obtaining a filler-containing molded body.

As a method of pressurizing, it is preferable to gradually apply pressure from atmospheric pressure until the desired pressure is reached.

The pressure applied to the mold is appropriately selected depending on a desired shape and hardness of the string-like filler-containing resin composition, but is preferably 0.1 to 20.0 MPa, and more preferably 0.5 to 5.0 MPa.

The temperature at which the mold is pressed is preferably from -10 to 40°C, and more preferably from 0 to 30°C.

The curing conditions of the string-shaped filler-containing resin composition are optimized depending on a type, etc. of the string-shaped filler-containing resin composition. For example, the curing conditions of the filler-containing molded body obtained from the string-shaped filler-containing resin composition using a silicone resin are preferably as follows.

The curing temperature is preferably 50 to 200°C, more preferably 100 to 150°C. The curing time is preferably 1 minute to 24 hours, more preferably 5 minutes to 1 hour.

### Slicing step (I-6)

The slicing step is a step to obtain thermally conductive sheets in a desired thickness by slicing the filler-containing molded body obtained in the molding step above. Specifically, the step goes through the following (i) or (ii).
(i) The filler-containing molded bodies are aligned so that their longitudinal directions are parallel to the X-axis direction in a mold, stacked in the Z-axis direction for filling, and sliced in parallel to the Y-Z plane.
(ii) The filler-containing molded bodies are aligned so that its longitudinal direction is parallel to the Y-axis direction in a mold, stacked in the Z-axis direction for filling, and sliced in parallel to the X-Z plane.
By slicing the above molded bodies in a desired thickness, thermally conductive sheets in which the longitudinal directions of the anisotropic fillers are oriented in the thickness direction can be obtained.

### [Method for Manufacturing Thermally Conductive Sheet (II)]

In addition, a method for manufacturing the inventive thermally conductive sheet different from the above manufacturing method is a method to obtain a thermally conductive sheet having excellent thermal conductivity in a thickness direction and low specific gravity by containing a high amount of the fillers through a process including:
(II-1) a preparing step of preparing a filler-containing resin composition comprising the polymer matrix (A) and the thermally conductive filler (B);
(II-2) an applying step of applying the filler-containing resin composition onto a film separator in a single direction so that the applied composition has a uniform thickness on the film separator;
(II-3) a heating step of heating the filler-containing resin composition to obtain a sheet-shaped filler-containing semi-cured resin composition;
(II-4) a cutting step of peeling off the sheet-shaped filler-containing semi-cured resin composition from the film separator, and then cutting the composition according to a size of a mold to be used in a molding step;
(II-5) the molding step of aligning cut pieces of the sheet-shaped filler-containing semi-cured resin composition in the direction of applying the resin composition and subjecting the cut pieces to heating and pressurization to obtain a filler-containing molded body; and
(II-6) a slicing step of slicing the filler-containing molded body to obtain thermally conductive sheets.

Hereinafter, each step of the above is described in detail.

### Preparing step (II-1)

In this step, a filler-containing resin composition containing the above polymer matrix (A) and the thermally conductive filler (B) is prepared according to the above method for manufacturing the filler-containing resin composition.

### Applying step (II-2)

The prepared filler-containing resin composition is applied in one direction onto the film separator so as to have a uniform thickness.

The filler-containing resin composition is applied with a baker-type film applicator or the like in one direction to have a uniform thickness onto the film separator, from which the sheet-shaped filler-containing semi-cured resin composition can be peeled off in a next heating step. By this application, the fillers can be aligned so that the long axis directions of the fillers are parallel to the applied direction of the sheet-shaped filler-containing semi-cured resin composition.

### Heating step (II-3)

The heating step is a step to obtain the sheet-shaped filler-containing semi-cured resin composition by heating the filler-containing resin composition. When the filler-containing resin composition contains a solvent, the heating step also includes a step for volatilizing the solvent by heating.

### Cutting step (II-4)

In the cutting step, the sheet-shaped filler-containing semi-cured resin composition obtained in the heating step above is peeled off from the film separator and cut according to a mold size used in the molding step. By setting the cutting size so that a width and a length are shorter than the inner dimensions of the mold by -0.3 to -1.0mm, it become easier to fill the sheet-shaped filler-containing semi-cured resin composition in the subsequent molding step.

### Molding step (II-5)

The obtained sheet-shaped filler-containing semi-cured resin compositions are alignged so that their flow direction of the application are parallel each other, and then heated pressurized, to obtain a filler-containing molded body.

### (Mold used in the molding step)

The mold used in the molding step is the same as the molding step (I-5) above.

### (Method for filling)

The sheet-shaped filler-containing semi-cured resin compositions obtained in the cutting step above is filled into the lower mold as follows.
(i) The sheets are alignged in the mold so that their flow direction of the application are in parallel to the X-axis direction of the mold, to be stacked in the Z-axis direction for filling.
(ii) The sheets are alignged in the mold so that their flow directions of the application are in parallel to the Y-axis direction of the mold, to be stacked in the Z-axis direction for filling.

In this way, a molded body in which anisotropic filler and the like are oriented can be obtained more preferably and efficiently.

The number of times that the sheets are stacked in the Z-axis direction is preferably two or more, and more preferably 5 to 3,000 times.

### (Method for molding)

In the molding step, the lower mold is pressed in the Z-axis direction by the upper mold; the sheet-shaped filler-containing resin composition is heated to cure completely; and a filler-containing molded body can be obtained.

As a method of applying pressure, it is preferable to gradually apply pressure from atmospheric pressure until the desired pressure is reached.

The pressure applied to the mold is appropriately selected depending on the desired shape and hardness of the sheet-shaped filler-containing resin composition, but it is preferably 0.1 to 20.0 MPa, and more preferably 0.5 to 5.0 MPa.

The temperature at which the mold is pressed is preferably from -10 to 40°C, and more preferably from 0 to 30°C.

The curing conditions of the sheet-shaped filler-containing resin composition are optimized according to a type of the sheet-shaped filler-containing resin composition, etc. For example, the curing conditions of the filler-containing molded body obtained from the sheet-shaped filler-containing resin composition using a silicone resin are preferable as follows.

The curing temperature is preferably 50 to 200°C, more preferably 100 to 150°C. The curing time is preferably 1 minute to 24 hours, more preferably 5 minutes to 1 hour.

### Slicing step (II-6)

The slicing step is a step to obtain a thermally conductive sheet in a desired thickness by slicing the molded body obtained in the molding step above. Specifically, the step goes through the following (i) and (ii).
(i) The molded body, which was made of the sheets filled in the mold so as to be aligneded so that their flow direction of the application were in parallel to the X-axis direction and to be stacked in the Z-axis direction, is sliced in parallel to the Y-Z plane.
(ii) the molded body, which was made of the sheets filled in the mold so as to be aligneded so that their flow direction of the application were in parallel to the Y-axis direction and to be stacked in the Z-axis direction, is sliced in parallel to the X-Z plane. By slicing the molded body as above in a desired thickness, thermally conductive sheets in which the longitudinal directions of the anisotropic fillers are oriented in the thickness direction can be obtained.

### [Thermally Conductive Sheet]

The inventive thermally conductive sheet has a thermal conductivity in the thickness direction of 15 W/m·K or more, and a degree of orientation in which the long axis direction of the thermally conductive filler contained in the thermally conductive sheet is oriented in the thickness direction of the thermally conductive sheet is 1.0 or more. Conventionally, the maximum thermal conductivity of a thermal conductive sheet highly filled with a general thermally conductive filler is about 13 W/m·K, which the inventive thermally conductive sheet exceeds.

When the degree of orientation is 1.0 or less, it is impossible to provide a thermally conductive sheet with a good thermal conductivity of 15 W/m·K or more. The method for measuring the degree of orientation is as described above.

In addition, the thermal conductivity can be measured using a laser flash method (LFA 447 Nanoflash, manufactured by NETZSCH-Gerätebau GmbH) in accordance with JIS R 1611:2010.

In addition, the inventive thermally conductive sheet has a low specific gravity, and the specific gravity is preferably less than 2.0. The lower limit of the specific gravity is not particularly limited, but can be, for example, 1.0 or more. The specific gravity value can be obtained by measuring the specific gravity at 25°C in accordance with JIS K 6249:2003.

Such a thermally conductive sheet of the present invention has excellent thermal conductivity in the thickness direction and a low specific gravity.

### EXAMPLE

Hereinafter, the present invention will be specifically described with reference to Examples and Comparative Examples. However, the present invention is not limited thereto. Note that, the kinetic viscosity is a value at 25°C when using a Cannon-Fenske viscometer described in JIS Z 8803:2011. The average fiber length, the average fiber diameter, and the aspect ratio are determined by SEM measurements. The average particle size is the cumulative average particle size (median diameter) on a volume basis measured by a particle size distribution measuring apparatus "Microtrac MT3300EX II", manufactured by MicrotracBEL Corp.

### <Filler-containing organopolysiloxane composition A>

A filler-containing organopolysiloxane composition A (specific gravity 1.3) was obtained by mixing 38.2 mass% of an addition reaction type organopolysiloxane composition (specific gravity 1.0), 22.6 mass% of carbon fiber (average fiber length 50 µm, average fiber diameter 10 µm, aspect ratio 5, specific gravity 2.2), 22.6 mass% of carbon fiber (average fiber length 250 µm, average fiber diameter 10 µm, aspect ratio 25, specific gravity 2.2), and 16.6 mass% of toluene (specific gravity 0.9).

The components of the addition reaction type organopolysiloxane composition are the following (A-1) to (A-3).

### Component (A-1)

Organopolysiloxane represented by the following formula: 97.1 mass% 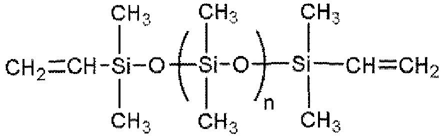 In the formula above, n is the number that gives a kinetic viscosity of 30,000 mm²/s at 25°C.

### Component (A-2)

Organohydrogenpolysiloxane represented by the following formula: 2.2 mass% 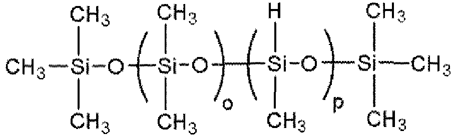 In the formula above, o=27, p=3, and each is the average degree of polymerization.

### Component (A-3)

### 5% 2-ethylhexanol solution of chloroplatinic acid: 0.7 mass %

### <Filler-containing organopolysiloxane composition B>

A filler-containing organopolysiloxane composition B (specific gravity 1.3) was obtained by mixing 31.1 mass% of addition reaction type organopolysiloxane composition (specific gravity 1.0), 23.6 mass% of carbon fiber (average fiber length 50 µm, average fiber diameter 10 µm, aspect ratio 5, specific gravity 2.2), 23.6 mass% of carbon fiber (average fiber length 250 µm, average fiber diameter 10 µm, aspect ratio 25, specific gravity 2.2), *and* 21.7 mass% of toluene (specific gravity 0.9).

### <Filler-containing organopolysiloxane composition C>

A filler-containing organopolysiloxane composition C (specific gravity 1.3) was obtained by mixing 23.5 mass% of addition reaction type organopolysiloxane composition (specific gravity 1.0), 24.6 mass% of carbon fiber (average fiber length 50 µm, average fiber diameter 10 µm, aspect ratio 5, specific gravity 2.2), 24.6 mass% of carbon fiber (average fiber length 250 µm, average fiber diameter 10 µm, aspect ratio 25, specific gravity 2.2), and 27.3 mass% of toluene (specific gravity 0.9).

### <Filler-containing organopolysiloxane composition D>

A filler-containing organopolysiloxane composition D (specific gravity 1.5) was obtained by mixing 18.5 mass% of an addition reaction type organopolysiloxane composition (specific gravity 1.0), 64.9 mass% of flaky boron nitride (average particle size 30 µm, aspect ratio 30, specific gravity 2.2), and 16.7 mass% of toluene (specific gravity 0.9).

### <Filler-containing organopolysiloxane composition E>

A filler-containing organopolysiloxane composition E (specific gravity 1.4) was obtained by mixing 45.8 mass% of addition reaction type organopolysiloxane composition (specific gravity 1.0), 27.1 mass% of carbon fiber (average fiber length 50 µm, average fiber diameter 10 µm, aspect ratio 5, specific gravity 2.2), and 27.1 mass% of carbon fiber (average fiber length 250 µm, average fiber diameter 10 µm, aspect ratio 25, specific gravity 2.2).

### (Toluene-free composition of the filler-containing organopolysiloxane composition A)

### <Filler-containing organopolysiloxane composition F>

A filler-containing organopolysiloxane composition F (specific gravity 1.7) was obtained by mixing 22.1 mass% of addition reaction type organopolysiloxane composition (specific gravity 1.0) and 77.9 mass% of flaky boron nitride (average particle size 30 µm, aspect ratio 30, specific gravity 2.2).

### (Toluene-free composition of the filler-containing organopolysiloxane composition D)

### <Mold>

The molds used in the Examples and Comparative Examples will be explained below with reference to the drawings.

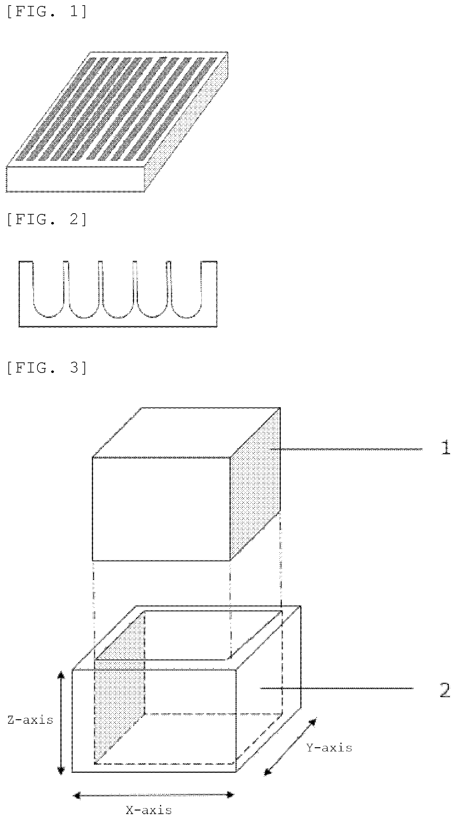

FIG. 1 shows a mold used in the filling step of the present invention. FIG. 2 shows a cross section of the mold used in the filling step above. FIG. 3 shows a mold used in the molding step.

### <Example 1>

Prepared were: a mold, used in the filling step, with a groove having a width of 1.5 mm, a length of 50.0 mm, a depth of 2.5 mm, and a semicircular bottom shape; a lower mold, used in the molding step, with inner dimensions of a width of 33.0 mm (X-axis), a length of 52.0 mm (Y-axis), and a depth of 50.0 mm (Z-axis); and an upper mold, used in the molding step, with a width of 32.9, a length of 51.9 mm, and a height of 40.0 mm.

The filler-containing organopolysiloxane composition A above was filled into the mold used in the filling step above so that it overflowed from the grooves, and the overflowed portion was scraped off with a squeegee.

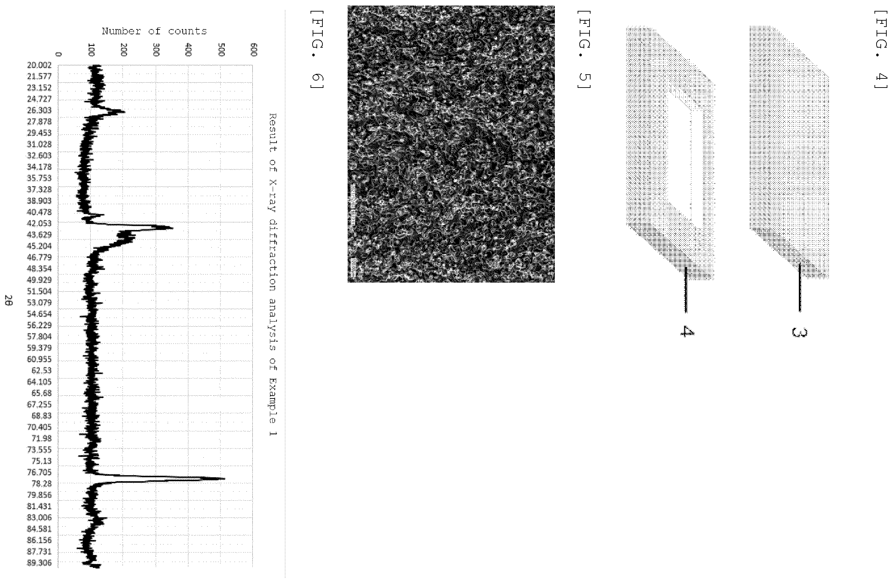

The mold, used in the filling step, filled with the filler-containing organopolysiloxane composition A was vibrated for 30 minutes in tabletop ultrasonic cleaning machine "UT-106" manufactured by a Sharp Corporation under conditions of a water temperature of 25°C, a frequency of 37 kHz, and an output of 100%, and then dried at 80°C for 2 minutes to obtain a string-shaped filler-containing resin composition A. Further, the string-shaped filler-containing resin compositions A were further filled in the lower mold 2 used in the molding step above so that they were aligned in the Y-axis direction to form 21 rows in the X-axis direction and 40 tiers in the Z-axis direction, and the upper mold 1 used in the molding step above was pressurized in the Z-axis direction at 1.0 MPa with a hydraulic press machine, and heated at 120°C under the pressurized conditions for 30 minutes to obtain a filler-containing molded body 1. The cured product, which is the above filler-containing molded body, was sliced in parallel to the X-Z plane with a cutter knife to obtain a thermally conductive sheet 1 having a thickness of 2 mm. A surface SEM image of the thermally conductive sheet 1 is shown in FIG. 5, and the result of the X-ray diffraction analysis is shown in FIG. 6.

### <Example 2>

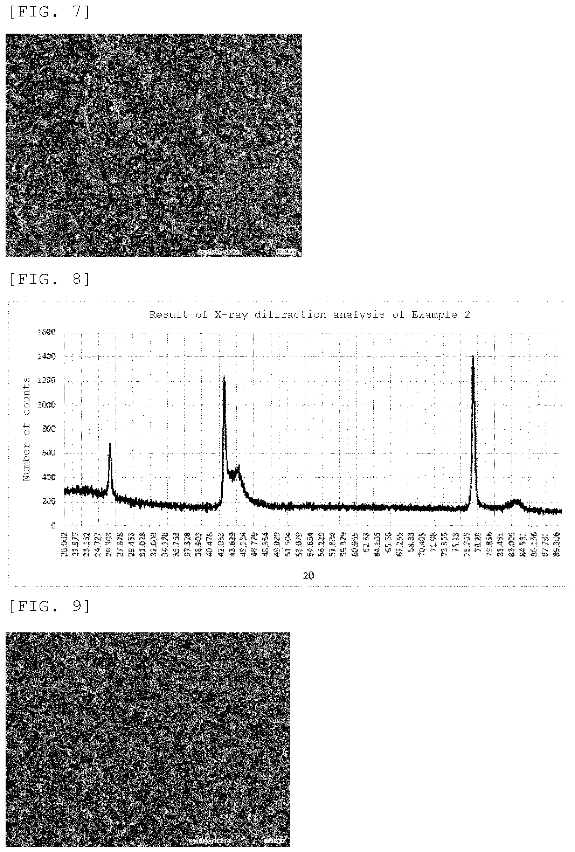

The above filler-containing organopolysiloxane composition was replaced with the above filler-containing organopolysiloxane composition B, and a thermally conductive sheet 2 was obtained according to the same manufacturing method as in Example 1. A surface SEM image of the thermally conductive sheet 2 is shown in FIG. 7, and the result of the X-ray diffraction analysis is shown in FIG. 8.

### <Example 3>

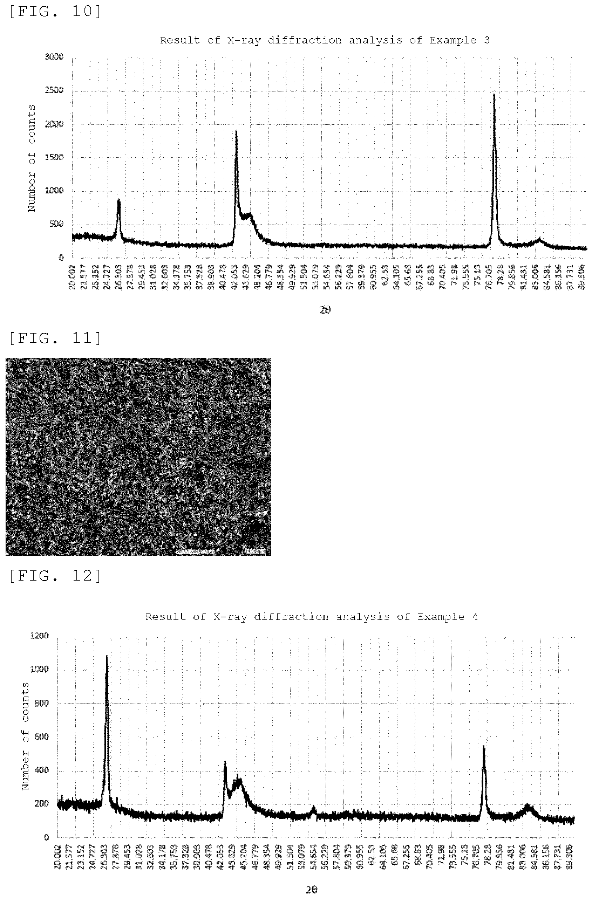

The above filler-containing organopolysiloxane composition was replaced with the above filler-containing organopolysiloxane composition C, and a thermally conductive sheet 3 was obtained according to the same manufacturing method as in Example 1. A surface SEM image of the thermally conductive sheet 3 is shown in FIG. 9, and the result of the X-ray diffraction analysis is shown in FIG. 10.

### <Example 4>

The above filler-containing organopolysiloxane composition A was applied onto a film separator surface-treated with fluorine using a Baker-type film applicator, and after drying at 80°C for 10 minutes, a sheet-shaped filler-containing resin composition A with a thickness of 500 to 550 um was obtained. Further, the above sheet-shaped filler-containing resin composition A was then cut into pieces having a width of 32.5 mm and a length of 51.5 mm. 80 cut pieces were stacked to be filled into a lower mold used in the molding step above, and heated at 120°C for 30 minutes under the condition in which the upper mold used in the molding step above was pressurized in the Z-axis direction at 1.0 MPa using a hydraulic press machine, and then a filler-containing molded body 4 was obtained.

The cured product, which is the above filler-containing molded body, was sliced in parallel to the X-Z plane with a cutter knife to obtain a thermally conductive sheet 4 having a thickness of 2 mm. A surface SEM image of the thermally conductive sheet 4 is shown in FIG. 11, and the result of the X-ray diffraction analysis is shown in FIG. 12.

### <Example 5>

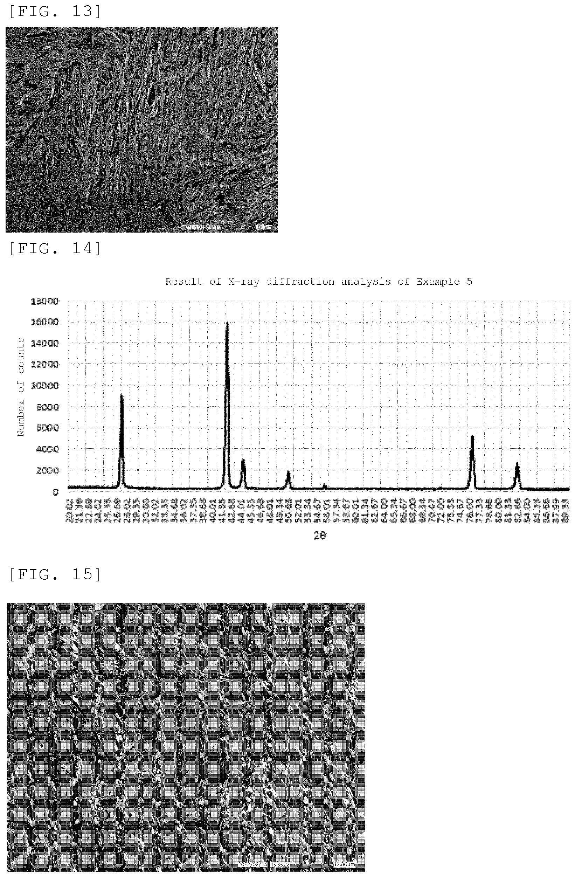

The above filler-containing organopolysiloxane composition was replaced with the above filler-containing organopolysiloxane composition D, and a thermally conductive sheet 5 was obtained according to the same manufacturing method as in Example 1. A surface SEM image of the thermally conductive sheet 5 is shown in FIG. 13, and the result of the X-ray diffraction analysis is shown in FIG. 14.

### <Example 6>

Prepared were: a mold, used in the filling step, with a groove having a width of 2.7 mm, a length of 50.0 mm, a depth of 2.5 mm, and a semicircular bottom shape; a lower mold, used in the molding step, with inner dimensions of a width of 33.0 mm (X-axis), a length of 52.0 mm (Y-axis), and a depth of 50.0 mm (Z-axis); and an upper mold, used in the molding step, with a width of 32.9, a length of 51.9 mm, and a height of 40.0 mm.

The above filler-containing organopolysiloxane composition A was filled into the mold used in the filling step above so that it overflowed from the grooves, and the overflowed portion was scraped off with a squeegee.

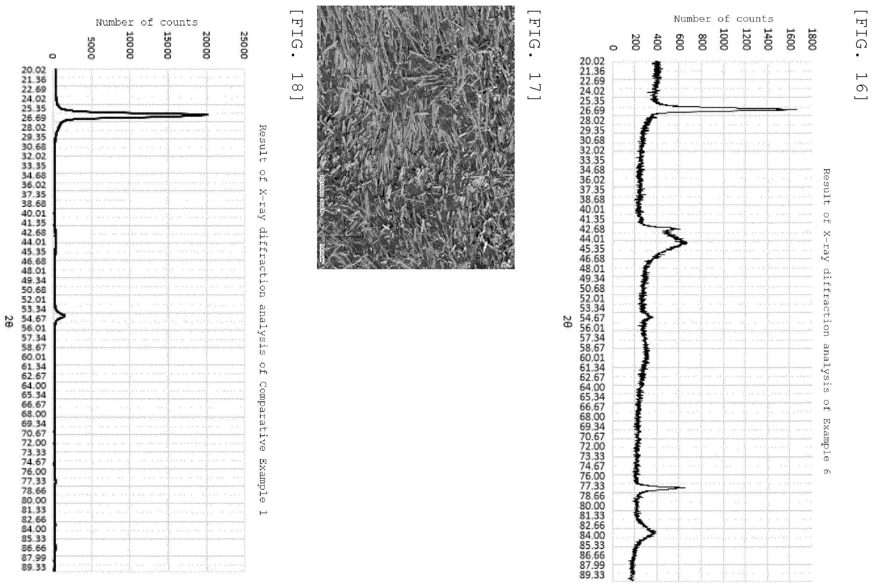

The mold, used in the filling step, filled with the above filler-containing organopolysiloxane composition A was vibrated for 30 minutes in tabletop ultrasonic cleaning machine "UT-106" manufactured by a Sharp Corporation under conditions of a water temperature of 25°C, a frequency of 37 kHz, and an output of 100%, and then dried at 80°C for 2 minutes to obtain a string-shaped filler-containing resin composition A. Further, the string-shaped filler-containing resin compositions A were further filled in the lower mold 2 used in the molding step above so that they were aligned in the Y-axis direction to form 12 rows in the X-axis direction and 40 tiers in the Z-axis direction, and the upper mold 1 used in the molding step above was pressurized in the Z-axis direction at 1.0 MPa with a hydraulic press machine, and heated at 120°C under the pressurized conditions for 30 minutes to obtain a filler-containing molded body 6. The cured product, which is the above filler-containing molded body, was sliced in parallel to the X-Z plane with a cutter knife to obtain a thermally conductive sheet 6 having a thickness of 2 mm. A surface SEM image of the thermally conductive sheet 6 is shown in FIG. 15, and the result of the X-ray diffraction analysis is shown in FIG. 16.

### <Comparative Example 1>

Prepared was a lower mold, shown in Fig. 4, with a concave portion having a width of 50 mm, a length of 50 mm, and a height of 2.0 mm. The mixture E was filled into the lower mold 4 above, and the mixture was hardened by applying a pressure of 10 MPa by way of the upper mold 3 with a hydraulic press machine, and cured by heating at 110°C for 30 minutes, and then a thermally conductive sheet 7 with a thickness of 2 mm is obtained.

As for a sheet obtained by slicing the thermally conductive sheet 7 in a thickness direction, a surface SEM image of the sheet is shown in FIG. 17, and the result of the X-ray diffraction analysis is shown in FIG. 18.

### <Comparative Example 2>

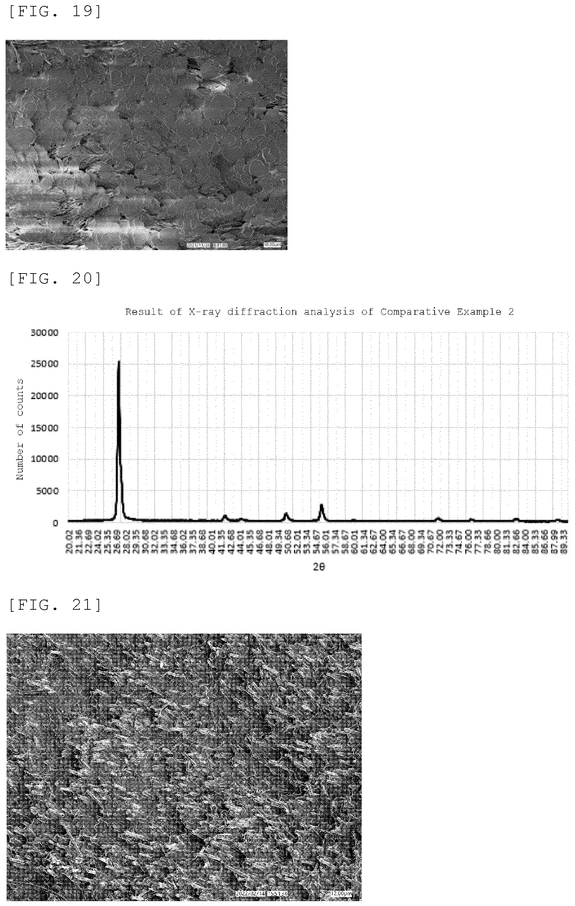

The above filler-containing organopolysiloxane composition was replaced with the above filler-containing organopolysiloxane composition F, and a thermally conductive sheet 8 was obtained according to the same manufacturing method as in Example 1. A surface SEM image of the thermally conductive sheet 7 is shown in FIG. 19, and the result of the X-ray diffraction analysis is shown in FIG. 20.

### <Comparative Example 3>

Prepared were: a mold, used in the filling step, with a groove having a width of 3.5 mm, a length of 50.0 mm, a depth of 2.5 mm, and a semicircular bottom shape; a lower mold, used in the molding step, with inner dimensions of a width of 33.0 mm (X-axis), a length of 52.0 mm (Y-axis), and a depth of 50.0 mm (Z-axis); and an upper mold, used in the molding step, with a width of 32.9, a length of 51.9 mm, and a height of 40.0 mm.

The above filler-containing organopolysiloxane composition A was filled into the mold used in the filling step above so that it overflowed from the grooves, and the overflowed portion was scraped off with a squeegee.

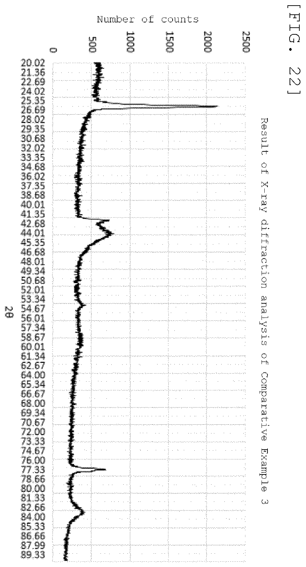

The mold, used in the filling step, filled with the above filler-containing organopolysiloxane composition A was vibrated for 30 minutes in tabletop ultrasonic cleaning machine "UT-106" manufactured by a Sharp Corporation under conditions of a water temperature of 25°C, a frequency of 37 kHz, and an output of 100%, and then dried at 80°C for 2 minutes to obtain a string-shaped filler-containing resin composition A. Further, the string-shaped filler-containing resin compositions A were further filled in the lower mold 2 used in the molding step above so that they were aligned in the Y-axis direction to form 9 rows in the X-axis direction and 40 tiers in the Z-axis direction, and the upper mold 1 used in the molding step above was pressurized in the Z-axis direction at 1.0 MPa with a hydraulic press machine, and heated at 120°C under the pressurized conditions for 30 minutes to obtain a filler-containing molded body 9. The cured product, which is the above filler-containing molded body, was sliced in parallel to the X-Z plane with a cutter knife to obtain thermally conductive sheets 9 having a thickness of 2 mm. A surface SEM image of the thermally conductive sheet 9 is shown in FIG. 21, and the result of the X-ray diffraction analysis is shown in FIG. 22.

### <Evaluation items>

### <Degree of orientation >

Each thermally conductive sheet obtained in Examples and Comparative Examples was punched out to be a circle with a diameter of 12.7 mm. The punched out was used as a test piece and measurements were performed using Benchtop powder X-ray powder diffraction instrument "D2 PHASER 2nd Generation" manufactured by Bruker Japan K.K. under the following conditions.
Scan range: 20 - 90°
Step size: 0.024°
Sample rotation: 10 rpm
Voltage: 30 kV
Current: 10 mA
The results calculated from the peak intensity of the measurements are shown in Table 1.
The degree of orientation is defined as follows; Orientation degree = {sum of vertical counts + (sum of diagonal counts/2)}/horizontal count.
Vertical count 2Θ = 41.0 to 43.0° (100) plane, 2Θ = 76.5 to 78.5° (110) plane
Diagonal count 2Θ = 43.5 to 45.5° (101) plane, 2Θ = 81.5 to 83.5° (112) plane
Horizontal count 2Θ = 25.5 to 27.5° (002) plane

### <Thermal conductivity>

Each thermally conductive sheet obtained in Examples and Comparative Examples was punched out to be a circle with a diameter of 12.7 mm. The punched out was used as a test piece and the thermal conductivity were measured using a laser flash method (LFA 447 Nanoflash, manufactured by NETZSCH-Gerätebau GmbH) in accordance with JIS R 1611:2010. The results are shown in Table 1.

### <Specific gravity>

For each thermally conductive sheet obtained in Examples and Comparative Examples, the specific gravity at 25°C was measured according to JIS K 6249:2003. The results are shown in Table 1.

**[Table 1]**

| | Example 1 | Example 2 | Example 3 | Example 4 | Example 5 | Example 6 | Comparative Example 1 | Comparative Example 2 | Comparative Example 3 |
|---|---|---|---|---|---|---|---|---|---|
| Filler-containing organopolysiloxane resin composition | A | B | C | A | D | A | E | F | A |
| Filler content of thermally conductive sheet (mass%) | 54.2 | 60.3 | 67.7 | 54.2 | 77.9 | 54.2 | 54.2 | 77.9 | 54.2 |
| Degree of orientation | 5.16 | 4.39 | 5.38 | 1.24 | 2.64 | 1.08 | 0.05 | 0.08 | 0.94 |
| 2θ ≈ 26.5° | 205 | 682 | 891 | 1085 | 9058 | 1666 | 20073 | 25305 | 2138 |
| 2θ ≈ 42.5° | 353 | 1251 | 1902 | 458 | 15871 | 611 | 356 | 1109 | 736 |
| 2θ ≈ 44.5° | 236 | 482 | 676 | 376 | 2980 | 673 | 384 | 637 | 798 |
| 2θ ≈ 77.5° | 512 | 1404 | 2443 | 549 | 5199 | 657 | 380 | 509 | 684 |
| 2θ ≈ 82.5° | 150 | 197 | 224 | 303 | 2683 | 396 | 290 | 311 | 365 |
| Thermal conductivity (W/m K) | 21.8 | 32.7 | 51.9 | 17.2 | 16.2 | 15.7 | 2.1 | 1.3 | 14.7 |
| Specific gravity | 1.4 | 1.5 | 1.6 | 1.4 | 1.7 | 1.4 | 1.4 | 1.7 | 1.4 |

When the thermally conductive sheets have the same carbon fiber filler amount of 54.2 mass%, Example 1 has a degree of orientation of 5.16 and a thermal conductivity of 21.8 W/m·K, Example 4 has a degree of orientation of 1.20 and a thermal conductivity of 17.2 W/m·K, and Example 6 has a degree of orientation of 1.08 and a thermal conductivity of 15.7 W/m·K. Further, Comparative Example 1 has a degree of orientation of only 0.05 and a thermal conductivity of only 2.1 W/m·K, and Comparative Example 3 has a degree of orientation of only 0.94 and a thermal conductivity of only 14.7 W/m·K. This means that, with the same filler amount, the thermal conductivity increases as the degree of orientation increases.

In addition, when comparing thermally conductive sheets with different mass% of the carbon fiber filler, Example 1 with 54.2 mass% has a degree of orientation of 5.16 and a thermal conductivity of 21.8 W/m K, Example 2 with 60.3 mass% has a degree of orientation of 4.40 and a thermal conductivity 32.7 W/m K, and Example 3 with 67.7 mass% has a degree of orientation of 5.43 and a thermal conductivity of 51.9 W/m K. This means that, with the similar degree of orientation, the thermal conductivity increases as the mas% of the filler increases.

Furthermore, when the thermally conductive sheets have the same boron nitride filler content of 77.9 mass%, while Example 5 has a degree of orientation of 2.64 and a thermal conductivity of 16.2 W/m K, Comparative Example 2 has a degree of orientation of 0.08 and a thermal conductivity of only 1.3 W/m K. This means that, with the same amount of the filler, a higher degree of orientation results in a higher thermal conductivity.

It should be noted that the present invention is not limited to the embodiments described above. The embodiments are just examples, and any examples that have substantially the same feature and demonstrate the same functions and effects as those in the technical concept disclosed in claims of the present invention are included in the technical scope of the present invention.

## Claims

1. A thermally conductive sheet comprising a thermally conductive filler (B) including at least one of carbon and boron nitride in a polymer matrix (A), wherein the thermally conductive sheet has a thermal conductivity in a thickness direction of 15 W/m-K or more and a degree of orientation in which a long axis direction of the thermally conductive filler is oriented in a thickness direction of the thermally conductive sheet is 1.0 or more.

2. The thermally conductive sheet according to claim 1, wherein the thermally conductive sheet has a specific gravity of less than 2.0.

3. The thermally conductive sheet according to claim 1 or 2, wherein the proportion of the component (B) contained in the thermally conductive sheet is 50 to 90 mass%.

4. The thermally conductive sheet according to any one of claims 1 to 3, wherein the component (A) is a curable polymer composition comprising at least one selected from the group consisting of organopolysiloxanes, polyurethanes, polyacrylates, perfluoropolyether elastomers, unsaturated polyester resins, polyamide resins, epoxy resins, and phenolic resins.

5. The thermally conductive sheet according to any one of claims 1 to 4, wherein a shape of the component (B) is fibrous, scaly, plate-like, flat, needle-like, or whisker.

6. The thermally conductive sheet according to any one of claims 1 to 5, wherein an aspect ratio of the component (B) is 2 or more.

7. A method for manufacturing the thermally conductive sheet according to any one of claims 1 to 6, comprising:
(I-1) a preparing step of preparing a filler-containing resin composition comprising the polymer matrix (A) and the thermally conductive filler (B);
(I-2) a filling step of filling a mold with the filler-containing resin composition;
(I-3) a vibrating step of defoaming and aligning the fillers by vibrating the mold with ultrasonic waves;
(I-4) a heating step of heating the filler-containing resin composition to obtain a string-shaped filler-containing semi-cured resin composition;
(I-5) a molding step of aligning the string-shaped filler-containing semi-cured resin compositions in a longitudinal direction and then subjecting the compositions to heating and pressurization to obtain a filler-containing molded body; and
(I-6) a slicing step of slicing the filler-containing molded body to obtain a thermally conductive sheet.

8. A method for manufacturing the thermally conductive sheet according to any one of claims 1 to 6, comprising:
(II-1) a preparing step of preparing a filler-containing resin composition comprising the polymer matrix (A) and the thermally conductive filler (B);
(II-2) an applying step of applying the filler-containing resin composition onto a film separator in a single direction so that the applied composition has a uniform thickness on the film separator;
(II-3) a heating step of heating the filler-containing resin composition to obtain a sheet-shaped filler-containing semi-cured resin composition;
(II-4) a cutting step of peeling off the sheet-shaped filler-containing semi-cured resin composition from the film separator, and then cutting the composition according to a size of a mold to be used in a molding step;
(II-5) a molding step of aligning the cut pieces of the sheet-shaped filler-containing semi-cured resin composition in the direction of applying the resin composition and subjecting the cut pieces to heating and pressurization to obtain a filler-containing molded body; and
(II-6) a slicing step of slicing the filler-containing molded body to obtain a thermally conductive sheet.

9. The method for manufacturing the thermally conductive sheet according to claim 7 or 8, wherein the filler-containing resin composition further comprises an organic solvent.
